# EUROPEAN PATENT APPLICATION

(11) **EP 4 653 177 A1**
(43) Date of publication of application: **26.11.2025**
(21) Application number: 23917902.1
(22) Date of filing: 18.12.2023
(51) Int. Cl.: B29C 64/124, B29C 64/277, B29C 64/245, B29C 64/393, B33Y 10/00, B33Y 30/00, B33Y 40/00, B33Y 50/02, B33Y 70/00, B82B 3/00

(54) **APPARATUS FOR MANUFACTURING HIGH-ASPECT-RATIO, HIGH-RESOLUTION FINE PATTERN, AND MANUFACTURING METHOD USING SAME**

(30) Priority: 17.01.2023 KR 20230006557; 17.01.2023 KR 20230006570
(71) Applicant: Changwon National University Industry Academy Cooperation Corps, Changwon-si, Gyeongsangnam-do 51140 (KR)
(72) Inventor: CHO, Young Tae, Changwon-si Gyeongsangnam-do 51427 (KR); KIM, Seok, Changwon-si Gyeongsangnam-do 51140 (KR); PARK, Seo Rim, Changwon-si Gyeongsangnam-do 51139 (KR); SHIN, Seung Woo, Changwon-si Gyeongsangnam-do 51454 (KR); KIM, Woo Young, Changwon-si Gyeongsangnam-do 51371 (KR); OH, Seung Min, Changwon-si Gyeongsangnam-do 51238 (KR)
(74) Representative: Prüfer & Partner mbB Patentanwälte · Rechtsanwälte
(86) International application number: PCT/KR2023/020850
(87) International publication number: WO 2024/154950

(57) **Abstract**

An apparatus for manufacturing a high-aspect-ratio, high-resolution fine pattern according to an embodiment of the present invention may comprise: a transparent substrate; a photocurable resin applied to one side of the transparent substrate and cured by light; a light source providing light to the other side of the transparent substrate to cure the photocurable resin; and a lens member which is disposed between the light source and the transparent substrate and focuses the light from the light source onto the other side of the transparent substrate to cure the photocurable resin into a high-aspect-ratio, high-resolution fine pattern according to a self-propagating polymer waveguide (SPPW) process.

## Description

### [Technical Field]

The present invention relates to an apparatus for manufacturing a high-aspect-ratio, high-resolution fine pattern and a manufacturing method using the same, and more particularly, to an apparatus for manufacturing a high-aspect-ratio, high-resolution fine pattern and a manufacturing method using the same in which a focusing phenomenon of lens technology is combined with a self-propagating photopolymer waveguide (SPPW) process for manufacturing a high-aspect-ratio fine pattern so that the high-aspect-ratio fine pattern can be fabricated with high resolution, and in which digital optical technology for controlling an irradiation pattern of light in the SPPW process is further combined so that the fine pattern of a high-aspect-ratio structure can be fabricated in various types of patterns.

### [Background Art]

In general, fine patterns having a high aspect ratio exhibit excellent physical and chemical properties due to structural effects such as a large specific surface area and control of photoelectronic behavior.

The characteristics of such high-aspect-ratio fine patterns correspond to a core technology capable of overcoming performance limitations of key devices in various fields including future mobility, energy/environment, and nano-bio.

For example, high-aspect-ratio fine patterns are applied to enhance the sensitivity of bio-sensors or gas sensors due to their large specific surface area, or to improve the energy efficiency of devices such as solar panels.

In addition, in recent years, the demand for products implementing special functions such as water repellency, oil repellency, antifouling, and anti-icing has been increasing, and functional films such as water-repellent or oil-repellent films are being fabricated by forming fine patterns of high-aspect-ratio structures on surfaces to provide these functions through structural characteristics. Such functional films having water repellency or oil repellency provide omniphobic surfaces having superhydrophobicity and superoleophobicity capable of repelling all types of liquids.

However, conventional fine patterns of high-aspect-ratio structures are fabricated at the micro-scale level through various processes such as photolithography and etching, but it is very difficult to fabricate them at the nano-scale level to further enhance the performance of the fine patterns.

### [Disclosure]

### [Technical Problem]

According to an embodiment of the present invention, there is provided an apparatus for manufacturing a high-aspect-ratio, high-resolution fine pattern and a manufacturing method using the same, in which a focusing phenomenon of lens technology is combined with a self-propagating photopolymer waveguide (SPPW) process for manufacturing a high-aspect-ratio fine pattern so that the high-aspect-ratio fine pattern can be fabricated with high resolution.

In addition, according to an embodiment of the present invention, there is provided an apparatus for manufacturing a high-aspect-ratio, high-resolution fine pattern and a manufacturing method using the same, in which a micro lens array (MLA) is applied to the SPPW process so that nano-scale fine patterns can be smoothly fabricated on a large-area substrate and the production efficiency of the nano-scale fine patterns can be maximized.

In addition, according to an embodiment of the present invention, there is provided an apparatus for manufacturing a high-aspect-ratio, high-resolution fine pattern and a manufacturing method using the same, in which the SPPW process for manufacturing a fine pattern of a high-aspect-ratio structure is combined with digital optical technology for freely controlling an irradiation pattern of light so that the fine pattern of the high-aspect-ratio structure can be fabricated in various types of patterns.

In addition, according to an embodiment of the present invention, there is provided an apparatus for manufacturing a high-aspect-ratio, high-resolution fine pattern and a manufacturing method using the same, in which a digital light processor (DLP) is applied to the SPPW process so that the irradiation pattern of light irradiated to a photo-curable resin can be freely changed, and various types of nano-scale fine patterns of the high-aspect-ratio structure can be smoothly fabricated using the same.

### [Technical Solution]

According to one embodiment of the present invention, there is provided an apparatus for manufacturing a high-aspect-ratio, high-resolution fine pattern, comprising: a transparent substrate; a photo-curable resin applied on one surface of the transparent substrate and curable by light; a light source configured to provide light to the other surface of the transparent substrate to cure the photo-curable resin; and a lens member disposed between the light source and the transparent substrate and configured to focus light from the light source onto the other surface of the transparent substrate to cure the photo-curable resin into a high-aspect-ratio, high-resolution fine pattern according to a self-propagating polymer waveguide (SPPW) process.

Preferably, the lens member may be provided as a micro lens array (MLA) having a substrate shape corresponding to the transparent substrate and disposed on the other surface of the transparent substrate. Preferably, the micro lens array may comprise at least one lens portion configured to focus light from the light source onto a focal position of the transparent substrate. The lens portion may be provided as an aspherical lens configured to form a focus at the focal position of the transparent substrate. The lens portions may be arranged in the micro lens array in a predetermined arrangement pattern. Accordingly, light from the light source may be irradiated onto focal positions of the transparent substrate corresponding to the arrangement pattern of the lens portions. In this case, the photo-curable resin may be cured at the focal positions of the transparent substrate to form the fine patterns with a high aspect ratio and high resolution.

Preferably, the high-aspect-ratio, high-resolution fine pattern manufacturing apparatus according to the present invention may further comprise a transfer stage connected to the lens member and the light source and configured to move the lens member and the light source along the other surface of the transparent substrate. In this case, the lens member may be provided as a micro lens array (MLA) having a substrate shape corresponding to the transparent substrate and disposed on the other surface of the transparent substrate, and the transparent substrate may have a surface area larger than that of the micro lens array. Therefore, the transfer stage may be configured to move the micro lens array and the light source along the other surface of the transparent substrate to form the fine pattern over an entire one surface of the transparent substrate.

Preferably, the transparent substrate may be divided into a plurality of divided regions according to the area of the micro lens array. The transfer stage may be configured to sequentially move the micro lens array and the light source along the divided regions of the transparent substrate to form the fine pattern region by region on one surface of the transparent substrate. Alternatively, the transfer stage may be configured to move the micro lens array and the light source from one region to another region of the transparent substrate to continuously form the fine pattern on one surface of the transparent substrate.

According to another embodiment of the present invention, there is provided an apparatus for manufacturing a high-aspect-ratio, high-resolution fine pattern, comprising: a transparent substrate; a photo-curable resin applied on one surface of the transparent substrate; a light source configured to generate light for curing the photo-curable resin; and a digital optical unit disposed between the light source and the transparent substrate and configured to irradiate the light from the light source toward the other surface of the transparent substrate in a predetermined irradiation pattern to cure the photo-curable resin into a high-aspect-ratio structure in a fine pattern corresponding to the irradiation pattern according to a self-propagating polymer waveguide (SPPW) process. Preferably, the digital optical unit may be provided as a digital light processor (DLP) configured to operate in any one mode of a plurality of processing modes corresponding to irradiation patterns of the light to process the irradiation pattern of the light irradiated to the other surface of the transparent substrate into a desired pattern.

Preferably, the high-aspect-ratio, high-resolution fine pattern manufacturing apparatus according to one embodiment of the present invention may further comprise a controller configured to select any one of the processing modes of the digital light processor and control operation of the digital light processor. The controller may select any one of the processing modes of the digital light processor, and the digital light processor may operate according to the processing mode selected by the controller to determine the irradiation pattern of the light irradiated to the transparent substrate. Preferably, the digital light processor may comprise: a digital mirror device (DMD) provided as a micro-mirror assembly configured to operate according to the processing mode selected by the controller and to irradiate light from the light source in an irradiation pattern corresponding to the processing mode; a first lens portion disposed between the digital mirror device and the light source and configured to receive the light from the light source and deliver the light to the digital mirror device; and a second lens portion disposed between the digital mirror device and the transparent substrate and configured to deliver light reflected and processed by the digital mirror device to the other surface of the transparent substrate.

Preferably, the digital mirror device may operate according to the processing mode selected by the controller to reflect the light from the first lens portion toward the other surface of the transparent substrate according to the irradiation pattern corresponding to the processing mode. Here, the controller may sequentially change the processing mode of the digital mirror device at predetermined intervals, and the digital mirror device may sequentially change the irradiation pattern of the light irradiated to the other surface of the transparent substrate at predetermined intervals. Alternatively, the transparent substrate may have a surface area larger than the irradiation pattern of the light irradiated from the digital optical unit, and the digital optical unit may be moved along the other surface of the transparent substrate to form the high-aspect-ratio structure over an entire one surface of the transparent substrate. Preferably, the first lens portion and the second lens portion may each be formed as a structure combining a plurality of lenses. The second lens portion may focus light delivered from the digital mirror device onto the transparent substrate to further miniaturize the fine pattern of the high-aspect-ratio structure. Preferably, the light source may be equipped with a collimation lens to impart directivity to the light irradiated to the digital optical unit.

According to another aspect of the present invention, there is provided a method for manufacturing a high-aspect-ratio fine pattern, comprising: irradiating light from a light source to a digital optical unit; irradiating the light from the digital optical unit to a transparent substrate according to a predetermined irradiation pattern; transmitting the light irradiated to the transparent substrate to a photo-curable resin applied on one surface of the transparent substrate; and curing the photo-curable resin into a high-aspect-ratio structure in a fine pattern corresponding to the irradiation pattern of the light according to a self-propagating polymer waveguide (SPPW) process. Here, in the step of irradiating the light to the transparent substrate according to the irradiation pattern, the processing mode of the digital light processor may be controlled to change the irradiation pattern of the light at predetermined intervals. In the step of curing the photo-curable resin into the high-aspect-ratio structure, different types of the high-aspect-ratio structure may be formed in the photo-curable resin according to changes in the irradiation pattern of the light.

In addition, the method for manufacturing a high-aspect-ratio fine pattern according to another aspect of the present invention may further comprise, after the step of curing the photo-curable resin into the high-aspect-ratio structure is completed, moving the light source and the digital optical unit to another portion of the transparent substrate with operation of the light source and the digital optical unit stopped, and then repeating from the step of irradiating the light from the light source to the digital optical unit.

### [Advantageous effects]

According to one embodiment of the present invention, a high-aspect-ratio, high-resolution fine pattern manufacturing apparatus can fabricate a high-aspect-ratio fine pattern with high resolution by combining a focusing phenomenon of lens technology with a self-propagating polymer waveguide (SPPW) process for manufacturing the high-aspect-ratio fine pattern.

In addition, the high-aspect-ratio, high-resolution fine pattern manufacturing apparatus according to one embodiment of the present invention can smoothly fabricate nano-scale fine patterns on a large-area substrate in a single process by applying a micro lens array (MLA) to the SPPW process, thereby maximizing production efficiency of the nano-scale fine patterns.

Furthermore, the high-aspect-ratio, high-resolution fine pattern manufacturing apparatus according to one embodiment of the present invention can have a simple structure in which a micro lens array is disposed between a transparent substrate and a light source used in the SPPW process, and can easily set various patterns of high-aspect-ratio, high-resolution fine patterns by changing the arrangement of lens portions provided in the micro lens array into various patterns.

Meanwhile, a high-aspect-ratio, high-resolution fine pattern manufacturing apparatus and a manufacturing method using the same according to another embodiment of the present invention can smoothly fabricate nano-scale fine patterns of a high-aspect-ratio structure by combining the SPPW process for manufacturing a fine pattern of a high-aspect-ratio structure with digital optical technology for freely controlling an irradiation pattern of light, and can easily fabricate various types of fine patterns of the high-aspect-ratio structure through the digital optical technology.

In addition, the high-aspect-ratio, high-resolution fine pattern manufacturing apparatus and manufacturing method using the same according to another embodiment of the present invention can freely change the irradiation pattern of light irradiated to a photo-curable resin by applying a digital light processor (DLP) to the SPPW process, and can easily fabricate various types of high-aspect-ratio fine patterns corresponding to high-aspect-ratio structures by adjusting the irradiation pattern of light through a simple control method for controlling the operation of the digital light processor.

Furthermore, the high-aspect-ratio, high-resolution fine pattern manufacturing apparatus and manufacturing method using the same according to another embodiment of the present invention can irradiate light from a light source onto a photo-curable resin in the form of a nano-scale fine pattern by using a digital light processor, and can freely set various irradiation patterns for irradiating light from the light source onto the photo-curable resin by selecting any one of the processing modes of the digital light processor.

In addition, since the high-aspect-ratio, high-resolution fine pattern manufacturing apparatus and manufacturing method using the same according to another embodiment of the present invention has a structure in which the digital light processor and the light source are moved along the transparent substrate in a state where their operation is stopped, high-aspect-ratio structures can be smoothly formed in the photo-curable resin applied over the entire one surface of the transparent substrate while changing the light-converging position of the transparent substrate.

### [Description of Drawings]

FIG. 1 is a conceptual diagram illustrating a high-aspect-ratio, high-resolution fine pattern manufacturing apparatus according to one embodiment of the present invention.
FIG. 2 is a reference diagram for explaining an SPPW (self-propagating polymer waveguide) process of the fine pattern manufacturing apparatus illustrated in FIG. 1.
FIG. 3 is a diagram showing an example of a micro lens array illustrated in FIG. 1.
FIGS. 4 and 5 are diagrams respectively showing fine pattern manufacturing apparatuses to which the micro lens array illustrated in FIG. 3 is applied.
FIG. 6 is a diagram illustrating a modification of the high-aspect-ratio, high-resolution fine pattern manufacturing apparatus according to one embodiment of the present invention.
FIG. 7 is a conceptual diagram illustrating a high-aspect-ratio, high-resolution fine pattern manufacturing apparatus according to another embodiment of the present invention.
FIG. 8 is a schematic diagram illustrating a process of manufacturing a high-aspect-ratio structure in the region "A" illustrated in FIG. 7.
FIGS. 9 and 10 are diagrams respectively illustrating a high-aspect-ratio fine pattern manufacturing method according to another embodiment of the present invention.
FIGS. 11, 12, and 13 are diagrams respectively showing the fine patterns of high-aspect-ratio structures manufactured according to the high-aspect-ratio fine pattern manufacturing method illustrated in FIG. 10, each magnified at different magnifications.

### [Best Mode]

Hereinafter, embodiments of the present invention will be described in detail with reference to the accompanying drawings. However, the present invention is not limited or restricted to the embodiments. The same reference numerals in the respective drawings denote the same elements.

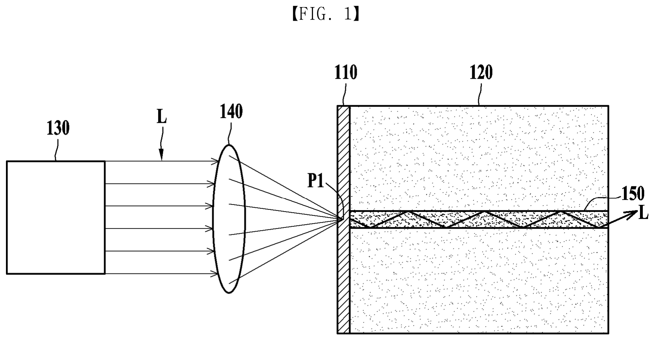

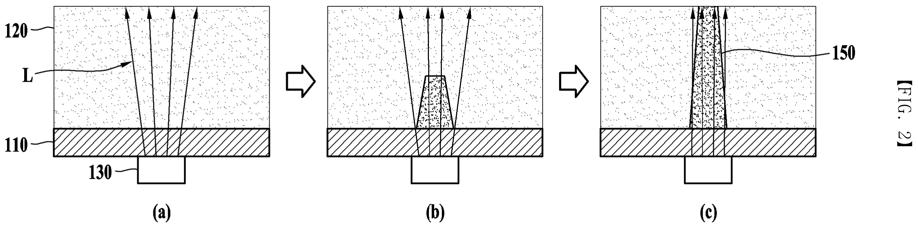

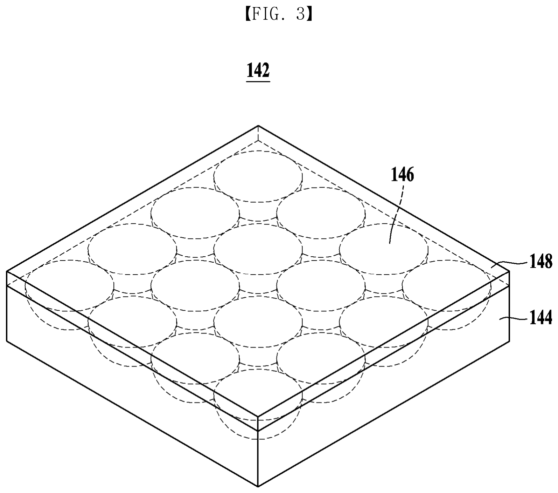

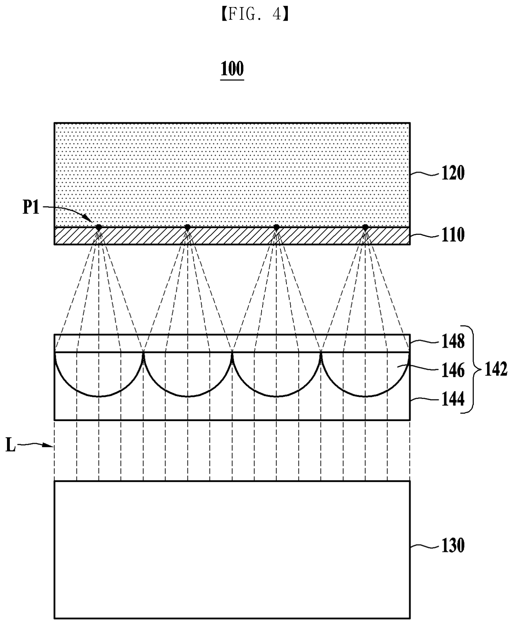

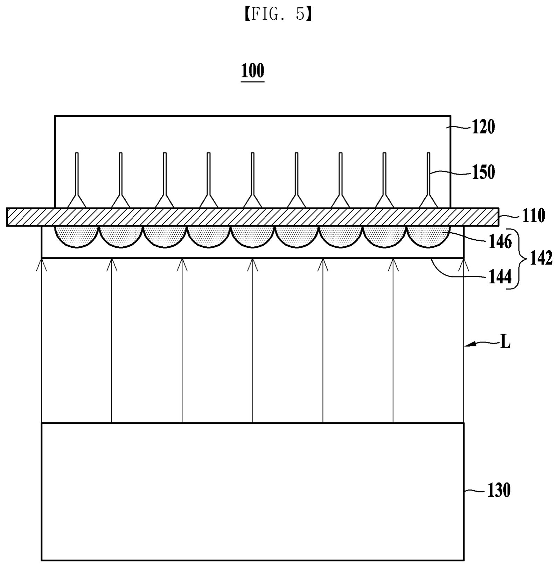

FIG. 1 is a conceptual diagram illustrating a high-aspect-ratio, high-resolution fine pattern manufacturing apparatus 100 according to one embodiment of the present invention, FIG. 2 is a reference diagram for explaining an SPPW (self-propagating polymer waveguide) process of the fine pattern manufacturing apparatus 100 illustrated in FIG. 1, and FIG. 3 is a diagram showing an example of a micro lens array 142 illustrated in FIG. 1. FIGS. 4 and 5 are diagrams respectively showing fine pattern manufacturing apparatuses 100 to which the micro lens array 142 illustrated in FIG. 3 is applied.

Referring to FIGS. 1 to 3, the high-aspect-ratio, high-resolution fine pattern manufacturing apparatus 100 according to one embodiment of the present invention may comprise a transparent substrate 110, a photo-curable resin 120, a light source 130, and a lens member 140.

The high-aspect-ratio, high-resolution fine pattern manufacturing apparatus 100 according to the present embodiment is an apparatus for fabricating a high-aspect-ratio fine pattern 150 with high resolution. To this end, the fine pattern manufacturing apparatus 100 of the present embodiment may be configured with a structure in which a focusing phenomenon of lens technology is combined with an SPPW process for fabricating the high-aspect-ratio fine pattern 150.

That is, the fine pattern manufacturing apparatus 100 of the present embodiment may focus light L from the light source 130 to a sub-micrometer level using the lens member 140, and irradiate the focused light onto the photo-curable resin 120 to cure the photo-curable resin 120 with finer precision. Accordingly, in the present embodiment, the photo-curable resin 120 can be cured with high resolution, and the high-aspect-ratio fine pattern 150 can be obtained at a nano-scale level.

Meanwhile, FIG. 1 schematically illustrates a conceptual diagram of the fine pattern manufacturing apparatus 100 according to the present embodiment, and the detailed configuration of the present invention will be described below with reference thereto.

Referring to FIG. 1, the transparent substrate 110 of the present embodiment is a thin substrate of a transparent material on which the high-aspect-ratio, high-resolution fine pattern 150 is formed, and may be formed of a material having excellent light transmittance and a low refractive index and reflectance. For example, in the present embodiment, the transparent substrate 110 may be provided as a thin glass substrate formed of a glass material.

Referring to FIG. 1, the photo-curable resin 120 of the present embodiment is a resin curable by light L from the light source 130, and may react with the light L from the light source 130 to be cured into the fine pattern 150. For example, in the present embodiment, the photo-curable resin 120 may be a UV-curable resin curable by ultraviolet light and formed of a transparent material allowing light transmission.

Here, the photo-curable resin 120 may be applied in a liquid state with a sufficient thickness on one surface of the transparent substrate 110. The photo-curable resin 120 in the liquid state as described above may undergo a curing reaction by the light L from the light source 130 to be formed into the fine pattern 150 in a solid state. Accordingly, the fine pattern 150, like the photo-curable resin 120, may be disposed on one surface of the transparent substrate 110.

In addition, the photo-curable resin 120 may be formed of a material having a refractive index of light L in a solid state that is relatively higher than the refractive index of light L in a liquid state. As illustrated in FIG. 2, as the light L from the light source 130 is irradiated onto the photo-curable resin 120 in a liquid state, the photo-curable resin 120 may be cured into a solid to form the fine pattern 150, and as the curing of such fine pattern 150 progresses, the path of light L may be concentrated into the fine pattern 150 so that a high-aspect-ratio fine pattern 150 can be formed through the SPPW (self-propagating polymer waveguide) process. The SPPW process technology as described above will be described in more detail below.

Referring to FIG. 1, the light source 130 of the present embodiment may provide light L to the other surface of the transparent substrate 110 to cure the photo-curable resin 120. For example, as the light source 130 of the present embodiment, a digital display capable of uniformly irradiating directional light L over the entire other surface of the transparent substrate 110 may be used. To this end, the light source 130 may be provided with a collimation lens (not shown) configured to make the light L parallel.

Referring to FIGS. 1 and 3, the lens member 140 of the present embodiment is a member configured to focus the light L from the light source 130 onto the other surface of the transparent substrate 110, and may be disposed between the light source 130 and the transparent substrate 110. The lens member 140 as described above may be formed in a lens structure of a transparent material. That is, when the lens member 140 focuses the light L from the light source 130 and then focuses it onto a desired position of the transparent substrate 110, a high-aspect-ratio, high-resolution fine pattern 150 can be smoothly obtained from the photo-curable resin 120 through the SPPW process.

As illustrated in FIG. 1, the lens member 140 may be provided as a convex lens for focusing the light L from the light source 130 onto the other surface of the transparent substrate 110. However, in the present embodiment, the lens member 140 is described as being provided as a micro lens array (MLA) 142 illustrated in FIG. 3. That is, the micro lens array 142 may focus the light L into micro-scale light and deliver it to a plurality of positions of the transparent substrate 110. The micro lens array 142 as described above may be provided in a substrate shape corresponding to the transparent substrate 110 and be disposed on the other surface of the transparent substrate 110.

For reference, the micro lens array 142 can significantly improve brightness by converging incident light with high precision, and since it is capable of controlling all physical properties of light L-namely luminous flux, polarization, and wavelength-it can create new added value by reducing its size or integrating functions according to use. For example, the higher the required brightness of the light L emitted from the light source 130, the larger the size of the light source 130 or the use of a high-performance light source 130 may be required, which presents a problem. However, when the micro lens array 142 is applied, it can be arranged side by side, thereby maintaining the same size of the fine pattern manufacturing apparatus 100 while overlapping the light L from the light source 130 at desired multiple positions to converge the light L onto those positions.

FIG. 3 illustrates an example of the micro lens array 142 applied to the fine pattern manufacturing apparatus 100 of the present embodiment.

As illustrated in FIG. 3, the micro lens array 142 of the present embodiment may comprise an array body 144, a lens portion 146, and a lens cover 148. The array body 144 may be formed in a substrate shape corresponding to the transparent substrate 110. The array body 144 as described above may be formed of the same transparent material as the lens portion 146. Hereinafter, in the present embodiment, the array body 144 is described as being manufactured in the same shape as the transparent substrate 110.

The lens portion 146 may focus the light L from the light source 130 onto a focal position P1 of the transparent substrate 110. Although at least one lens portion 146 may be formed in the array body 144, hereinafter, it is described that a plurality of lens portions 146 are arranged in the array body 144 to be spaced apart at a predetermined distance.

Here, the lens portion 146 may be provided as an aspherical lens configured to form a focus at the focal position P1 of the transparent substrate 110. That is, the lens portion 146 may be formed as an integral structure having a hemispherical recess on a surface of the array body 144 facing the other surface of the transparent substrate 110.

In addition, the lens portions 146 may be arranged in the array body 144 in a predetermined arrangement pattern. Accordingly, the light L from the light source 130 may be irradiated onto focal positions P1 of the transparent substrate 110 corresponding to the arrangement pattern of the lens portions 146. In this case, the light L from the light source 130 may be focused to a nano-scale level at the focal positions P1 of the transparent substrate 110, and the photo-curable resin 120 may be photo-cured at the focal positions P1 of the transparent substrate 110 so that a high-aspect-ratio, high-resolution fine pattern 150 is formed at each of the focal positions P1.

The lens cover 148 may be mounted on a surface of the array body 144 on which the lens portions 146 are formed so as to cover the lens portions 146. The lens cover 148 may be formed of a material having excellent light transmittance and a low refractive index and reflectance, similar to the transparent substrate 110, and may also prevent foreign substances from entering the interior of the lens portions 146 in advance.

Meanwhile, the fine pattern 150 of the present embodiment may be elongated to a nano scale at the focal positions P1 of the transparent substrate 110 by the light L from the light source 130 focused by the lens portions 146 of the micro lens array 142. The fine patterns 150 as described above may be formed as nano-scale pillar structures protruding from the other surface of the transparent substrate 110 and may be elongated with a thin thickness and a high height to have a high aspect ratio and high resolution.

FIG. 2 schematically illustrates a method of forming a high-aspect-ratio fine pattern 150 through an SPPW (self-propagating polymer waveguide) process of the fine pattern manufacturing apparatus 100 according to the present embodiment. For reference, in the present embodiment, for convenience of explanation, the light source 130 is described as being in close contact with the other surface of the transparent substrate 110.

As illustrated in FIG. 2, in the SPPW process for manufacturing the high-aspect-ratio fine pattern 150, when curing occurs in the photo-curable resin 120, a minute difference in refractive index between the cured solid portion (e.g., fine pattern) and the uncured liquid portion may occur, and a self-focusing effect, that is, a nonlinear effect, may be generated by a lensing effect according to the refractive index difference, while preventing the propagating light L from diverging (see FIGS. 2(a) and 2(b)).

Through the nonlinear effect of such light L, the photo-curable resin 120 may be cured along the propagation direction of the light L in the manner of a waveguide, resulting in the fine pattern 150 being elongated and grown (see FIG. 2(c)). At this time, by controlling the change in refractive index between the photo-curable resin 120 in the liquid state and the fine pattern 150 in the solid state and the maximum possible transparency at the wavelength of the light L, it is possible to form the fine pattern 150 having a size of micro-scale or smaller and a high aspect ratio.

In conclusion, the SPPW process technology of the present embodiment can manufacture a high-aspect-ratio, high-resolution fine pattern 150 by utilizing a nonlinear optical phenomenon in which the photopolymerization reaction is aligned along the propagation direction of the light L through an optical waveguide effect caused by a minute change in refractive index generated by the photopolymerization reaction.

FIGS. 4 and 5 illustrate fine pattern manufacturing apparatuses 100 in which the micro lens array 142 according to one embodiment of the present invention is applied in different ways.

As illustrated in FIG. 4, the lens portions 146 of FIG. 4 may be formed to have a very long focal length, and in such a case, the micro lens array 142 may be disposed at a predetermined distance from the other surface of the transparent substrate 110 corresponding to the focal length of the lens portions 146. Accordingly, in the fine pattern manufacturing apparatus 100 of the present embodiment, since the installation position of the micro lens array 142 is determined according to the focal length of the lens portions 146, the design position of the micro lens array 142 and the transparent substrate 110 must be appropriately set according to the design conditions and circumstances of the lens portions 146 of the micro lens array 142.

As illustrated in FIG. 5, the lens portions 146 of FIG. 5 may be formed so that the focus is located on the other surface of the transparent substrate 110 in contact with the micro lens array 142. When the lens portions 146 are formed as described above, the micro lens array 142 may be disposed in contact with the other surface of the transparent substrate 110. Accordingly, the micro lens array 142 has the advantage of being able to be placed more easily and stably on the other surface of the transparent substrate 110 compared to the fine pattern manufacturing apparatus 100 illustrated in FIG. 4.

As described above, the fine pattern manufacturing apparatus 100 of the present embodiment can variously change the arrangement position of the micro lens array 142 and the transparent substrate 110 according to the focal length of the lens portions 146 of the micro lens array 142, and can set the light-converging positions P1 of the light L formed on the transparent substrate 110 in various patterns by simply changing the arrangement pattern of the lens portions 146 arranged in the micro lens array 142.

In particular, in the fine pattern manufacturing apparatus 100 of the present embodiment, the resolution of the fine pattern 150 can be variously adjusted by changing the focusing ability of the lens portion 146, the wavelength of the light L emitted from the light source 130, and the material properties of the lens portion 146 and the photo-curable resin 120. In addition, in the fine pattern manufacturing apparatus 100 of the present embodiment, it is also possible to change the irradiation area and irradiation amount of the light L irradiated to the light-converging positions P1 of the transparent substrate 110 by adjusting the distance between the micro lens array 142 and the transparent substrate 110.

The operation and effects of the high-aspect-ratio, high-resolution fine pattern manufacturing apparatus 100 according to one embodiment of the present invention configured as described above are as follows.

As illustrated in FIG. 5, the light source 130 irradiates light L to the lens portions 146 of the micro lens array 142, and the lens portions 146 of the micro lens array 142 focus the light L onto the light-converging positions P1 of the transparent substrate 110.

The light L focused onto the light-converging positions P1 as described above passes through the transparent substrate 110 and is respectively delivered to portions of the photo-curable resin 120 corresponding to the light-converging positions P1 of the transparent substrate 110.

When the photo-curable resin 120 begins to be cured by the light L irradiated to the light-converging positions P1, fine patterns 150 are formed at portions of the photo-curable resin 120 corresponding to the light-converging positions P1 through the SPPW process, and the fine patterns 150 are gradually elongated as the delivery of the light L continues.

In the SPPW process technology as described above, the micro lens array 142 can be used to focus the size of the light L provided to the photo-curable resin 120 to be extremely small in order to form the high-aspect-ratio fine pattern 150. That is, since the light L passes through the micro lens array 142 before being irradiated to the photo-curable resin 120, the light L is focused by the lens portions 146 of the micro lens array 142, resulting in the cured portions of the photo-curable resin 120 being formed to be very narrow, and the intensity of the light L irradiated to the photo-curable resin 120 being increased.

By utilizing this, in the present embodiment, by applying the micro lens array 142 to the SPPW process technology, the fine pattern 150 can be easily fabricated at a nano-scale smaller than the conventional minimum micro-scale, and the nano-scale fine pattern 150 can be fabricated with high resolution on one surface of the transparent substrate 110.

Meanwhile, in the present embodiment, the arrangement pattern of the lens portions 146 can be changed through a simple method of replacing the micro lens array 142, and through this, the pattern shape of the fine pattern 150 formed on the transparent substrate 110 can be variously changed. Furthermore, in the present embodiment, the resolution of the fine pattern 150 formed on the transparent substrate 110 can be increased to a desired level by changing the shape of the lens portions 144 of the micro lens array 142, changing the material properties of the lens portions 144, the transparent substrate 110, and the photo-curable resin 120, or changing the wavelength of the light L irradiated from the light source 130.

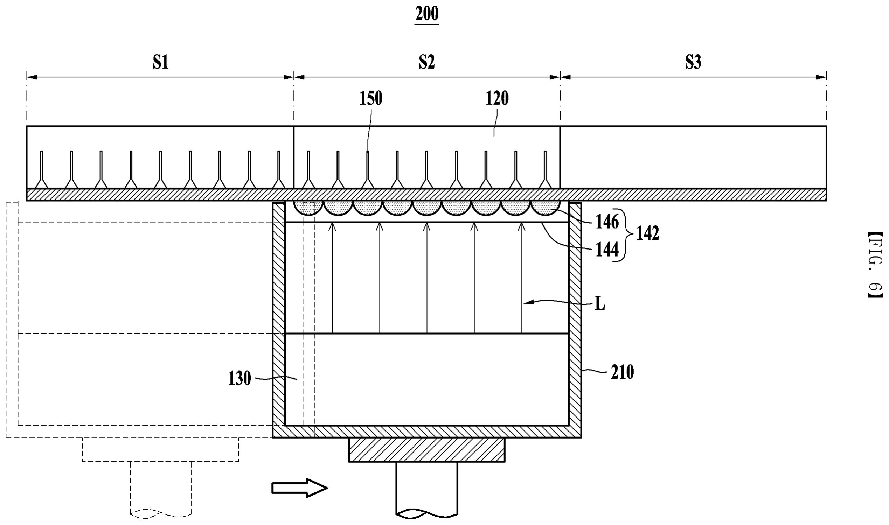

FIG. 6 is a diagram illustrating a modification of a high-aspect-ratio, high-resolution fine pattern manufacturing apparatus 200 according to one embodiment of the present invention.

In FIG. 6, the same or similar reference numerals as those shown in FIGS. 1 to 5 denote the same elements, and detailed descriptions thereof will be omitted. Hereinafter, the description will focus on differences from the fine pattern manufacturing apparatus 100 illustrated in FIGS. 1 to 5.

Referring to FIG. 6, the difference between the high-aspect-ratio, high-resolution fine pattern manufacturing apparatus 200 according to the modification of the present embodiment and the fine pattern manufacturing apparatus 100 illustrated in FIGS. 1 to 5 is that the apparatus 200 further comprises a transfer stage 210 configured to move the lens member 140 and the light source 130 along the other surface of the transparent substrate 110.

That is, the transfer stage 210 of the present modification may be configured to move the lens member 140 and the light source 130 together to a desired position of the transparent substrate 110 while supporting them simultaneously. The transfer stage 210 as described above may be detachably connected to the lens member 140 and the light source 130.

Here, the lens member 140 may be provided as a micro lens array (MLA) 142 having a substrate shape, and the transfer stage 210 may be any type of stage device capable of precisely transferring the substrate-shaped micro lens array 142 and the light source 130 relative to the other surface of the transparent substrate 110. The transfer stage 210 as described above may be provided with a separate mount portion for detachably installing the micro lens array 142 and the light source 130. The transfer stage 210 may move the mount portion in a horizontal direction along the other surface of the transparent substrate 110, but depending on the design conditions and circumstances of the fine pattern manufacturing apparatus 200, the mount portion may also be moved in a vertical direction relative to the other surface of the transparent substrate 110.

In addition, the transparent substrate 110 of the present modification may be formed to have a surface area larger than that of the micro lens array 142. In this case, the transfer stage 210 of the present modification may be operated to precisely move the micro lens array 142 and the light source 130 along the other surface of the transparent substrate 110.

Accordingly, when the transfer stage 210 transfers the micro lens array 142 and the light source 130 along the other surface of the transparent substrate 110, the process of forming the fine pattern 150 may be repeated several times, making it possible to form the fine pattern 150 over an entire one surface of the transparent substrate 110.

As illustrated in FIG. 6, one surface of the transparent substrate 110 of the present modification may be divided into a plurality of divided regions S1, S2, and S3 corresponding to the area of the micro lens array 142. For example, the transparent substrate 110 may be divided into a first divided region S1, a second divided region S2, and a third divided region S3, and the micro lens array 142 may be sequentially moved along the first divided region S1, the second divided region S2, and the third divided region S3 by the transfer stage 210.

The transfer stage 210 of the present modification may selectively move the micro lens array 142 and the light source 130 to any one of the divided regions S1, S2, and S3 of the transparent substrate 110. Accordingly, when the fine pattern manufacturing apparatus 200 is operated with the micro lens array 142 and the light source 130 selectively positioned in the divided regions S1, S2, and S3, the fine pattern 150 may be sequentially formed in the divided regions S1, S2, and S3, and as a result, the fine patterns 150 may be arranged with high resolution over the entire one surface of the transparent substrate 110 as high-aspect-ratio pillar structures.

Therefore, in the present modification, it is possible to smoothly form the high-aspect-ratio, high-resolution fine pattern 150 on the large-area transparent substrate 110, and since the fine pattern 150 is formed on the transparent substrate 110 even when the size of the micro lens array 142 and the light source 130 is smaller than that of the transparent substrate 110, the manufacturing cost of the micro lens array 142 and the light source 130 can be reduced.

Meanwhile, unlike the transfer stage 210 illustrated in FIG. 6, the transfer stage 210 may continuously move the micro lens array 142 and the light source 130 from one region of the transparent substrate 110 to another region. That is, the micro lens array 142 and the light source 130 may slide at an appropriate speed along the other surface of the transparent substrate 110 to continuously form the fine pattern 150 on one surface of the transparent substrate 110. Accordingly, elongated fine patterns 150 may be formed in various patterns over the entire one surface of the transparent substrate 110. However, in the present modification, the description will be made with reference to FIG. 6 in which the transfer stage 210 selectively moves the micro lens array 142 and the light source 130 to the divided regions S1, S2, and S3.

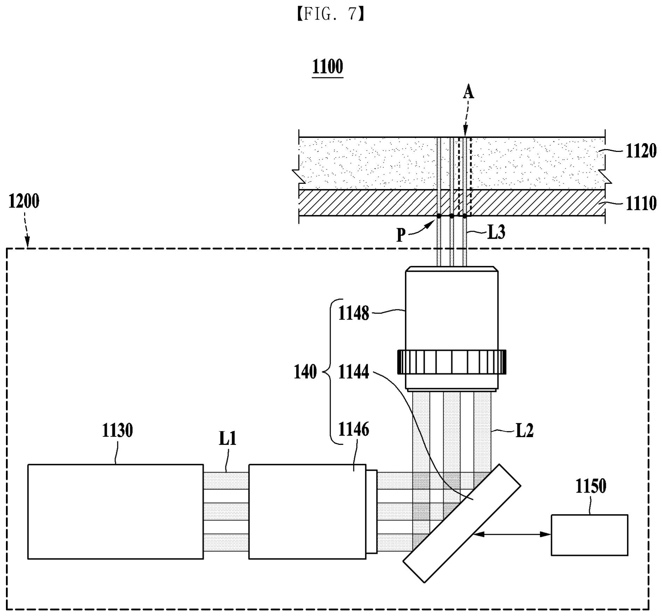

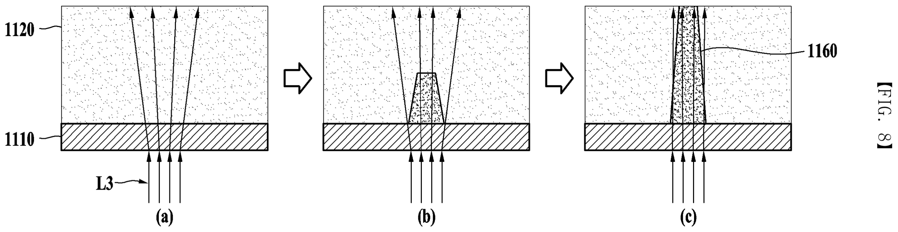

FIG. 7 is a conceptual diagram illustrating a high-aspect-ratio, high-resolution fine pattern manufacturing apparatus 1100 according to another embodiment of the present invention, and FIG. 8 is a schematic diagram illustrating a process of manufacturing a high-aspect-ratio structure 1160 in the region "A" illustrated in FIG. 7.

Referring to FIGS. 7 and 8, the high-aspect-ratio, high-resolution fine pattern manufacturing apparatus 1100 according to another embodiment of the present invention may comprise a transparent substrate 1110, a photo-curable resin 1120, a light source 1130, a digital optical unit 1140, and a controller 1150.

The high-aspect-ratio, high-resolution fine pattern manufacturing apparatus 1100 according to the present embodiment is an apparatus for manufacturing a fine pattern comprising a plurality of high-aspect-ratio structures 1160 by using a free-design type 3D printing method. To this end, the fine pattern manufacturing apparatus 1100 of the present embodiment may be configured with a structure in which a digital optical technology for freely controlling an irradiation pattern of light is combined with an SPPW (self-propagating polymer waveguide) process for manufacturing a fine pattern of the high-aspect-ratio structures 1160.

That is, the fine pattern manufacturing apparatus 1100 of the present embodiment can finely focus light L1 from the light source 1130 to a micro-scale or nano-scale using the digital optical unit 1140, and can irradiate the finely focused light L3 to the photo-curable resin 1120 to cure the photo-curable resin 1120 to a sub-nano pattern level. Accordingly, in the present embodiment, the digital optical unit 1140 can process light L1 from the light source 1130 to be smoothly set into various irradiation patterns of a freely designed type, and the irradiation pattern of the light L1 can finely cure the photo-curable resin 1120 to easily form a fine pattern of the high-aspect-ratio structures 1160 at a nano-scale level.

Meanwhile, FIG. 7 schematically illustrates a conceptual diagram of the high-aspect-ratio, high-resolution fine pattern manufacturing apparatus 1100 according to the present embodiment, and the detailed configuration of the present invention will be described below with reference thereto.

Referring to FIG. 7, the transparent substrate 1110 of the present embodiment is a thin substrate of a transparent material on which the fine pattern of the high-aspect-ratio structures 1160 is formed, and may be formed of a material having excellent light transmittance and a low refractive index and reflectance. For example, in the present embodiment, the transparent substrate 1110 may be provided as a thin glass substrate formed of a glass material.

Referring to FIG. 7, the photo-curable resin 1120 of the present embodiment is a resin curable by light L1, L2, and L3 from the light source 1130, and may react with the light from the light source 1130 to be cured into the high-aspect-ratio structures 1160. For example, in the present embodiment, the photo-curable resin 1120 may be a UV-curable resin curable by ultraviolet light and formed of a transparent material allowing light transmission.

Here, the photo-curable resin 1120 may be applied in a liquid state with a sufficient thickness on one surface of the transparent substrate 1110. The photo-curable resin 1120 in the liquid state as described above may undergo a curing reaction by light L1, L2, and L3 from the light source 1130 to form the high-aspect-ratio structures 1160 in a solid state as a fine pattern. In this case, the high-aspect-ratio structures 1160 may be provided, like the photo-curable resin 1120, on one surface of the transparent substrate 1110.

In addition, the photo-curable resin 1120 may be formed of a material in which the refractive index of the light L3 in a solid state is relatively higher than the refractive index of the light L3 in a liquid state. As illustrated in FIG. 8, as the light L1 from the light source 1130 is irradiated onto the photo-curable resin 1120 in a liquid state, the irradiated portions of the photo-curable resin 1120 may be cured to form high-aspect-ratio structures 1160 in a solid state. In this case, as the curing of the high-aspect-ratio structures 1160 progresses, the path of the light L3 irradiated to the photo-curable resin 1120 tends to be concentrated into the high-aspect-ratio structures 1160, thereby enabling the formation of the high-aspect-ratio structures 1160 through the SPPW (self-propagating polymer waveguide) process. The SPPW process technology as described above will be described in more detail below.

FIG. 8 continuously illustrates a process of forming a fine pattern of the high-aspect-ratio structures 1160 through the SPPW process of the fine pattern manufacturing apparatus 1100 according to the present embodiment. For reference, in the present embodiment, for convenience of explanation, the manufacturing process of the high-aspect-ratio structures 1160 will be described in detail in the region "A" of FIG. 7.

As illustrated in FIG. 8, the process technology for manufacturing the high-aspect-ratio structures 1160 according to the SPPW process may cause a minute difference in refractive index between the cured solid portion (for example, the high-aspect-ratio structures 1160) and the uncured liquid portion of the photo-curable resin 1120 applied on one surface of the transparent substrate 1110 when curing occurs, and by a lensing effect according to the refractive index difference, the propagating light L3 may generate a self-focusing effect, that is, a nonlinear effect, without diverging (see FIGS. 8(a) and 8(b)).

Through the nonlinear effect of such light L3, the photo-curable resin 1120 may be cured along the propagation direction of the light L3 in the manner of a waveguide, and accordingly, the high-aspect-ratio structures 1160 may grow in length (see FIG. 8(c)). At this time, by controlling the change in refractive index between the photo-curable resin 1120 in a liquid state and the high-aspect-ratio structures 1160 in a solid state, as well as the maximum possible transparency at the wavelength of the light L3, it is possible to form a fine pattern of the high-aspect-ratio structures 1160 having a size at or below the nano level and a high aspect ratio.

In conclusion, the SPPW process technology of the present embodiment can manufacture a fine pattern of the high-aspect-ratio structures 1160 on the photo-curable resin 1120 applied to one surface of the transparent substrate 1110 by utilizing a nonlinear optical phenomenon in which the photopolymerization reaction is aligned along the propagation direction of the light L3 through an optical waveguide effect caused by a minute change in refractive index generated by the photopolymerization reaction.

Referring to FIG. 7, the light source 1130 of the present embodiment may provide light L1, L2, and L3 to the other surface of the transparent substrate 1110 to cure the photo-curable resin 1120. For example, as the light source 1130 of the present embodiment, a digital display capable of uniformly irradiating directional light L1, L2, and L3 over the entire other surface of the transparent substrate 1110 may be used. To this end, the light source 1130 may be equipped with a collimation lens (not shown) configured to make the light L1, L2, and L3 irradiated to the digital optical unit 1140 into parallel light to enhance the directivity of the light L1, L2, and L3.

Referring to FIGS. 7 and 8, the digital optical unit 1140 of the present embodiment may process the light L1 from the light source 1130 into various irradiation patterns and then provide the processed irradiation pattern light L3 as a fine pattern of nano-scale or smaller onto the other surface of the transparent substrate 1110. The digital optical unit 1140 as described above may be disposed between the light source 1130 and the transparent substrate 1110. That is, the digital optical unit 1140 of the present embodiment may cure the high-aspect-ratio structures 1160 in the photo-curable resin 1120 in a fine pattern corresponding to the irradiation pattern of the light L3 according to the SPPW process by irradiating the light L1 from the light source 1130 toward the other surface of the transparent substrate 1110 in a predetermined irradiation pattern.

As illustrated in FIG. 7, the digital optical unit 1140 may be provided as a digital light processor (DLP) 1142 operating in any one of a plurality of processing modes corresponding to the irradiation patterns of the light L1, L2, and L3. The digital light processor 1142 as described above may operate to process the irradiation pattern of the light L3 irradiated to the other surface of the transparent substrate 1110 into a desired pattern. For reference, the digital light processor 1142 may irradiate the light L3 onto the other surface of the transparent substrate 1110 in an irradiation pattern combining shapes such as square, pentagon, circle, ellipse, polygon, straight line, and curved line.

For example, the digital light processor 1142 of the present embodiment may comprise a digital mirror device (DMD) 1144, a first lens portion 1146, and a second lens portion 1148. The digital mirror device 1144 may be operated according to a processing mode selected by the controller 1150, and may be provided as a micro-mirror assembly configured to irradiate the light L1, L2, and L3 from the light source 1130 in an irradiation pattern corresponding to the processing mode. Here, the digital mirror device 1144 may reflect the light L2 from the light source 1130, which is delivered by the first lens portion 1146, toward the other surface of the transparent substrate 1110.

For reference, the digital optical processor 1142 may cure and laminate the photo-curable resin 1120 on an area basis by irradiating the light L1 in a freely designed pattern onto the transparent substrate 1110 through the digital mirror device 1144. Accordingly, whereas in the prior art, a photomask for selectively irradiating light L1 is applied to the SPPW process, in the present embodiment, the photomask is not required due to the use of the digital optical processor 1142, thereby providing an advantage that the fine pattern of the high-aspect-ratio structures 1160 can be freely produced in a desired form for printing only by performing 3D modeling work.

The first lens portion 1146 may receive the light L1 from the light source 1130 and deliver it to the digital mirror device 1144. The first lens portion 1146 as described above may be disposed between the digital mirror device 1144 and the light source 1130.

The second lens portion 1148 may deliver the light L2 reflected by the digital mirror device 1144 to the other surface of the transparent substrate 1110. The second lens portion 1148 as described above may be disposed between the digital mirror device 1144 and the transparent substrate 1110. The second lens portion 1148 may focus the light L2 delivered from the digital mirror device 1144 onto the transparent substrate 1110 to further refine the fine pattern of the high-aspect-ratio structures 1160.

Meanwhile, the first lens portion 1146 and the second lens portion 1148 may each be formed in a structure combining a plurality of lenses. However, the lens arrangement structures of the first lens portion 1146 and the second lens portion 1148 may be designed in various combinations depending on the design conditions and circumstances of the digital light processor 1142.

For reference, the digital light processor 1142 can significantly improve the brightness of the light L3 irradiated to the photo-curable resin 1120 by precisely focusing the light L1 from the light source 1130, and since it is capable of controlling all physical properties of light, such as luminous flux, polarization, and wavelength, it can be reduced in size or integrated with functions according to use to create new added value. For example, the higher the required brightness of the light L1 irradiated from the light source 1130, the larger the size of the light source 1130 or the use of a high-performance light source 1130 may be required, which can be problematic. However, when the digital light processor 1142 is applied, it is possible to arrange it side-by-side so that the size of the fine pattern manufacturing apparatus 1100 can be maintained while simultaneously focusing the light L3 to desired multiple positions.

Referring to FIG. 7, the controller 1150 of the present embodiment may select any one of the processing modes of the digital light processor 1142 and control the operation of the digital light processor 1142. The controller 1150 may be controllably connected to the digital mirror device 1144 of the digital light processor 1142. Accordingly, the operation of the digital mirror device 1144 can be appropriately controlled simply by freely designing the operation program of the controller 1150, and the light L1 from the light source 1130 can be processed into various illumination patterns according to the operation of the digital mirror device 1144.

The controller 1150 as described above may select any one of the processing modes of the digital light processor 1142 and then appropriately control the operation of the digital mirror device 1144 according to the selected processing mode. Accordingly, the digital light processor 1142 may operate according to the processing mode selected by the controller 1150 to determine the irradiation pattern of the light L3 irradiated to the transparent substrate 1110 in various patterns.

As illustrated in FIG. 7, in the present embodiment, the digital light processor 1142, the light source 1130, and the controller 1150 may be integrated into a light pattern control module 1200. However, the present invention is not limited thereto, and the light pattern control module 1200 of the present embodiment may be formed of only the digital light processor 1142 and the light source 1130 depending on the design conditions and circumstances of the fine pattern manufacturing apparatus 1100.

The controller 1150 of the present embodiment may control the operation of the digital light processor 1142 so as to continuously change the processing modes of the digital light processor 1142 at predetermined intervals. Specifically, the controller 1150 may change the processing modes of the digital light processor 1142 at predetermined time intervals as needed, thereby enabling the fine pattern of the high-aspect-ratio structures 1160 to be manufactured in various illumination patterns by changing the irradiation pattern of the light L2 irradiated to a portion of the transparent substrate 1110 at predetermined time intervals.

In addition, the digital light processor 1142 of the present embodiment may be moved along the other surface of the transparent substrate 1110 so as to form the high-aspect-ratio structures 1160 over the entire one surface of the transparent substrate 1110. For reference, the transparent substrate 1110 may be formed with a surface area larger than the irradiation pattern of the light L1, L2, and L3 irradiated from the digital light processor 1142, and the light pattern control module 1200 may be disposed to be movable along the other surface of the transparent substrate 1110.

For example, the digital light processor 1142 of the present embodiment may form the high-aspect-ratio structures 1160 in the photo-curable resin 1120 at a first position of the transparent substrate 1110, and after the formation of the high-aspect-ratio structures 1160 at the first position of the transparent substrate 1110 is completed, it may move to a second position of the transparent substrate 1110 to again form the high-aspect-ratio structures 1160 in the photo-curable resin 1120. As illustrated in FIG. 7, in the present embodiment, since the digital light processor 1142, the light source 1130, and the controller 1150 are integrated into a single light pattern control module 1200, the light pattern control module 1200 may be horizontally moved along the other surface of the transparent substrate 1110 by a transfer stage unit or a robot unit.

In particular, in the fine pattern manufacturing apparatus 1100 of the present embodiment, the resolution of the high-aspect-ratio structures 1160 can be variously adjusted by changing the focusing ability of the digital optical unit 1140, the wavelength of the light L1, L2, and L3 irradiated from the light source 1130, and the material properties of the digital optical unit 1140 and the photo-curable resin 1120. In addition, in the fine pattern manufacturing apparatus 1100 of the present embodiment, it is also possible for the digital light processor 1142 of the digital optical unit 1140 to change the irradiation pattern of the light L3 irradiated to the light-converging position P2 of the transparent substrate 1110, thereby changing the irradiation area and irradiation amount of the light L3.

The operation and effects of the high-aspect-ratio, high-resolution fine pattern manufacturing apparatus 1100 according to another embodiment of the present invention configured as described above are as follows.

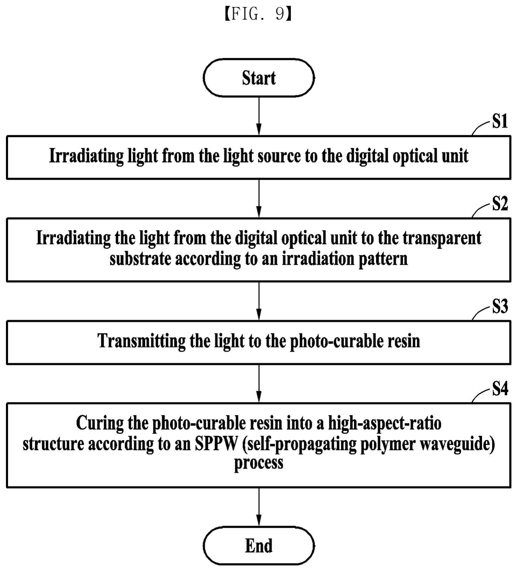

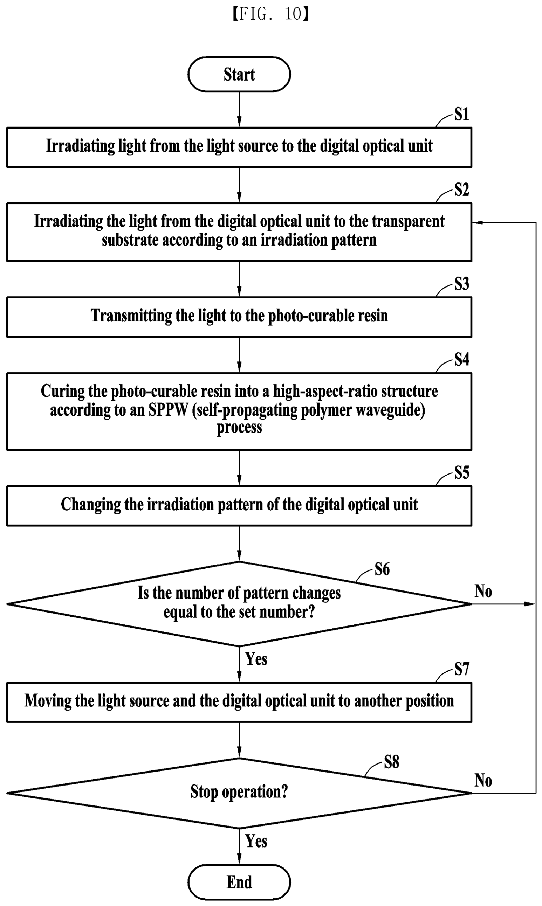

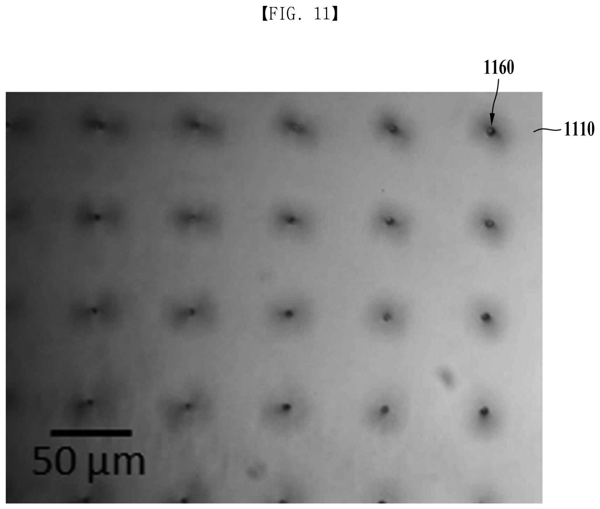

FIGS. 9 and 10 are diagrams respectively illustrating a high-aspect-ratio fine pattern manufacturing method according to another embodiment of the present invention, and FIGS. 11, 12, and 13 are diagrams showing the fine pattern of the high-aspect-ratio structures 1160 manufactured according to the high-aspect-ratio fine pattern manufacturing method illustrated in FIG. 9, each magnified at different scales.

Referring to FIG. 9, the high-aspect-ratio fine pattern manufacturing method according to the present embodiment may comprise:
a step S1 of irradiating light L1 from the light source 1130 to the digital optical unit 1140;
a step S2 of the digital optical unit 1140 irradiating light L3 from the light source 1130 onto the transparent substrate 1110 according to a predetermined irradiation pattern;
a step S3 of delivering the light irradiated to the transparent substrate 1110 to the photo-curable resin 1120 applied on one surface of the transparent substrate 1110; and
a step S4 of curing the high-aspect-ratio structures 1160 in the photo-curable resin 1120 according to the SPPW (self-propagating polymer waveguide) process in a fine pattern corresponding to the irradiation pattern of the light L3 irradiated to the photo-curable resin 1120.

In the step S1 of irradiating light L1 from the light source 1130 to the digital optical unit 1140, the light source 1130 irradiates directional light L1 to the first lens portion 1146 of the digital optical unit 1140.

In the step S2 of the digital optical unit 1140 irradiating light L3 onto the transparent substrate 1110 according to the irradiation pattern, the digital optical unit 1140 processes the light L1 from the light source 1130 according to the predetermined irradiation pattern and then irradiates the processed light L3 toward the other surface of the transparent substrate 1110 in the irradiation pattern. At this time, the light L3 irradiated toward the other surface of the transparent substrate 1110 is set to a desired irradiation pattern by the digital optical unit 1140 and is formed into a fine pattern of nano-scale or smaller by the digital optical unit 1140.

In the step S3 of delivering the light L3 to the photo-curable resin 1120, the light L3 is irradiated in the desired irradiation pattern onto the light-converging position P2 of the transparent substrate 1110, and the light L3 passes through the transparent substrate 1110 to be irradiated onto the photo-curable resin 1120 applied on one surface of the transparent substrate 1110.

In the step S4 of curing the high-aspect-ratio structures 1160 in the photo-curable resin 1120, the high-aspect-ratio structures 1160 are cured in the photo-curable resin 1120 into a fine pattern corresponding to the irradiation pattern of the light L3 irradiated to the photo-curable resin 1120.

When the photo-curable resin 1120 begins to be cured by the light L3 irradiated to the light-converging positions P2 as described above, a fine pattern of the high-aspect-ratio structures 1160 corresponding to the irradiation pattern of the light L3 is formed in the photo-curable resin 1120. That is, in the portions of the photo-curable resin 1120 corresponding to the light-converging positions P2, a fine pattern of the high-aspect-ratio structures 1160 is formed through the SPPW process, and the high-aspect-ratio structures 1160 are gradually elongated as the delivery of the light L3 continues.

In particular, in the SPPW process technology of the present embodiment, it is possible to very finely focus the size of the light L3 provided to the photo-curable resin 1120 for forming the high-aspect-ratio structures 1160 by using the digital optical unit 1140. That is, since the light L3 passes through the digital optical unit 1140 before being irradiated to the photo-curable resin 1120, the light L1, L2, and L3 are focused by the digital optical unit 1140, thereby forming an extremely fine curing area in the photo-curable resin 1120 and increasing the intensity of the light L3 irradiated to the photo-curable resin 1120.

By utilizing this, in the present embodiment, by applying the digital optical unit 1140 to the SPPW process technology, the fine pattern of the high-aspect-ratio structures 1160 can be easily manufactured in nano-scale units smaller than the conventional minimum micro-scale units, and the nano-scale fine pattern can be manufactured with high resolution on one surface of the transparent substrate 1110.

FIG. 10 illustrates another example of the high-aspect-ratio fine pattern manufacturing method according to the present embodiment. That is, in FIG. 10, the same or similar reference numerals as those illustrated in FIG. 9 denote the same steps, and a detailed description thereof will be omitted. Hereinafter, the description will focus on the differences from the high-aspect-ratio fine pattern manufacturing method illustrated in FIG. 9.

Referring to FIG. 10, the differences between the high-aspect-ratio fine pattern manufacturing method according to another modification of the present invention and the fine pattern manufacturing method illustrated in FIG. 9 are that the digital optical unit 1140 freely changes the illumination pattern of the light L1, L2, and L3 (see steps S5 to S6), and that the digital optical unit 1140, the light source 1130, and the controller 1150 are moved (see steps S7 to S8).

Here, in the step S2 (and S5 to S6) of the digital optical unit 1140 irradiating the light L3 onto the transparent substrate 1110 according to the irradiation pattern, the irradiation pattern of the light L3 may be changed by controlling the processing mode of the digital light processor 1142. Accordingly, in the step S4 of curing the high-aspect-ratio structures 1160 in the photo-curable resin 1120, high-aspect-ratio structures 1160 of different types may be formed in the photo-curable resin 1120 according to the fine patterns corresponding to the changes in the irradiation pattern of the light L1, L2, and L3.

By changing the processing mode of the digital light processor 1142 as described above, it is possible to manufacture various patterns of the high-aspect-ratio structures 1160 in various forms in the photo-curable resin 1120 applied to the transparent substrate 1110.

Meanwhile, the transparent substrate 1110 may be formed with a surface area larger than the irradiation pattern of the light L1, L2, and L3 irradiated from the digital light processor 1142 (steps S7 to S8). That is, based on the irradiation area of the digital light processor 1142, it is preferable to divide the transparent substrate 1110 into a plurality of divided regions and sequentially provide the illumination pattern of the light L3 to the divided regions of the transparent substrate 1110 by the digital light processor 1142.

The digital light processor 1142 as described above may be configured to be movable along the other surface of the transparent substrate 1110. Accordingly, the digital light processor 1142 may sequentially form the high-aspect-ratio structures 1160 over the entire one surface of the transparent substrate 1110 while moving along the transparent substrate 1110.

As illustrated in FIG. 10, the high-aspect-ratio fine pattern manufacturing method according to another modification of the present invention may, after the step S4 of curing the high-aspect-ratio structures 1160 in the photo-curable resin 1120 is completed, again perform the steps starting from step S7 and step S8 of moving the light source 1130 and the digital optical unit 1140 to another region of the transparent substrate 1110 in a state where the operation of the light source 1130 and the digital optical unit 1140 is stopped, and then irradiating the light L1, L2, and L3 from the light source 1130 to the digital optical unit 1140.

As described above, in the present embodiment, it is possible to smoothly form high-aspect-ratio structures in various fine patterns by changing the irradiation pattern of the digital light processor 1142 up to a set number of times, and at the same time, to easily form the high-aspect-ratio structures 1160 over the entirety of the photo-curable resin 1120 applied to the large-area transparent substrate 1110 through the SPPW process while moving the position of the digital light processor 1142.

FIGS. 11 to 13 illustrate the high-aspect-ratio structures 1160 and the high-aspect-ratio fine patterns thereof manufactured by the high-aspect-ratio fine pattern manufacturing method according to the present embodiment described above.

FIG. 11 shows the high-aspect-ratio fine pattern magnified at a low magnification. It can be confirmed that high-aspect-ratio structures 1160 are arranged at regular intervals on the transparent substrate 1110 of FIG. 11.

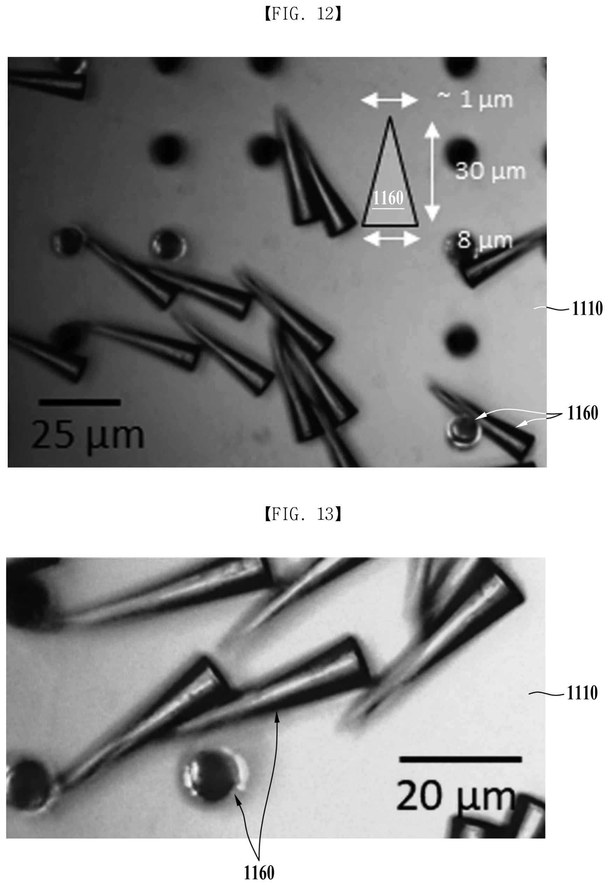

FIG. 12 shows the high-aspect-ratio fine pattern magnified at a magnification twice as high as that of FIG. 11. In the transparent substrate 1110 of FIG. 11, the high-aspect-ratio structures 1160 are arranged at regular intervals, and it can be confirmed that some of the high-aspect-ratio structures 1160 are separated from the transparent substrate 1110. It can also be confirmed that the high-aspect-ratio structures 1160 are manufactured in an elongated conical shape, although the invention is not limited thereto, and it is also possible to manufacture them in the shape of a cylinder or a polygonal pyramid.

FIG. 13 shows the high-aspect-ratio fine pattern magnified at a magnification higher than that of FIG. 12. In FIG. 13, the shape of the conical high-aspect-ratio structures 1160 can be more clearly identified, and it may be possible to separate these high-aspect-ratio structures 1160 from the transparent substrate 1110 and attach them to another substrate for use.

As described above, the embodiments of the present invention have been explained with reference to specific features such as detailed components, limited embodiments, and drawings, but these are provided only to assist in a more general understanding of the present invention, and the present invention is not limited to the above embodiments. It will be understood by those of ordinary skill in the art to which the present invention pertains that various modifications and variations can be made from the foregoing description. Therefore, the spirit of the present invention should not be construed as being limited to the described embodiments, and all equivalents or equivalent modifications to the claims set forth below, as well as the claims themselves, are to be construed as falling within the scope of the spirit of the present invention.

### [Industrial Applicability]

Included in the specification.

## Claims

1. An apparatus for manufacturing a high-aspect-ratio, high-resolution fine pattern, comprising:
a transparent substrate;
a photo-curable resin applied on one surface of the transparent substrate, the photo-curable resin being curable by light;
a light source configured to provide light to the other surface of the transparent substrate to cure the photo-curable resin; and
a lens member disposed between the light source and the transparent substrate, the lens member being configured to focus light from the light source onto the other surface of the transparent substrate to cure the photo-curable resin into a high-aspect-ratio, high-resolution fine pattern according to a self-propagating polymer waveguide (SPPW) process.

2. The apparatus of claim 1, wherein the lens member is provided as a micro lens array (MLA) having a substrate shape corresponding to the transparent substrate and disposed on the other surface of the transparent substrate.

3. The apparatus of claim 2, wherein the micro lens array comprises at least one lens portion configured to focus light from the light source onto a focal position of the transparent substrate.

4. The apparatus of claim 3, wherein the lens portion is provided as an aspherical lens configured to form a focus at the focal position of the transparent substrate.

5. The apparatus of claim 3, wherein:
the lens portions are arranged in the micro lens array in a predetermined arrangement pattern;
light from the light source is irradiated onto focal positions of the transparent substrate corresponding to the arrangement pattern of the lens portions; and
the photo-curable resin is cured at the focal positions of the transparent substrate to form the fine patterns with a high aspect ratio and high resolution.

6. The apparatus of claim 1, further comprising a transfer stage connected to the lens member and the light source, the transfer stage being configured to move the lens member and the light source along the other surface of the transparent substrate.

7. The apparatus of claim 6, wherein:
the lens member is provided as a micro lens array (MLA) having a substrate shape corresponding to the transparent substrate and disposed on the other surface of the transparent substrate;
the transparent substrate has a surface area larger than that of the micro lens array; and
the transfer stage is configured to move the micro lens array and the light source along the other surface of the transparent substrate to form the fine pattern over an entire one surface of the transparent substrate.

8. The apparatus of claim 7, wherein:
the transparent substrate is divided into a plurality of divided regions according to the area of the micro lens array; and
the transfer stage is configured to sequentially move the micro lens array and the light source along the divided regions of the transparent substrate to form the fine pattern region by region on one surface of the transparent substrate.

9. The apparatus of claim 7, wherein the transfer stage is configured to move the micro lens array and the light source from one region to another region of the transparent substrate to continuously form the fine pattern on one surface of the transparent substrate.

10. An apparatus for manufacturing a high-aspect-ratio, high-resolution fine pattern, comprising:
a transparent substrate;
a photo-curable resin applied on one surface of the transparent substrate;
a light source configured to generate light for curing the photo-curable resin; and
a digital optical unit disposed between the light source and the transparent substrate, the digital optical unit being configured to irradiate the light from the light source toward the other surface of the transparent substrate in a predetermined irradiation pattern to cure the photo-curable resin into a high-aspect-ratio structure in a fine pattern corresponding to the irradiation pattern according to a self-propagating polymer waveguide (SPPW) process.

11. The apparatus of claim 10, wherein the digital optical unit is provided as a digital light processor (DLP) configured to operate in any one mode of a plurality of processing modes corresponding to irradiation patterns of the light to process the irradiation pattern of the light irradiated to the other surface of the transparent substrate into a desired pattern.

12. The apparatus of claim 11, further comprising a controller configured to select any one of the processing modes of the digital light processor and control operation of the digital light processor, wherein the digital light processor operates according to the processing mode selected by the controller to determine the irradiation pattern of the light irradiated to the transparent substrate.

13. The apparatus of claim 12, wherein the digital light processor comprises:
a digital mirror device (DMD) provided as a micro-mirror assembly configured to operate according to the processing mode selected by the controller and to irradiate light from the light source in an irradiation pattern corresponding to the processing mode;
a first lens portion disposed between the digital mirror device and the light source, the first lens portion being configured to receive the light from the light source and deliver the light to the digital mirror device; and
a second lens portion disposed between the digital mirror device and the transparent substrate, the second lens portion being configured to deliver light reflected and processed by the digital mirror device to the other surface of the transparent substrate.

14. The apparatus of claim 13, wherein the digital mirror device operates according to the processing mode selected by the controller to reflect the light from the first lens portion toward the other surface of the transparent substrate according to the irradiation pattern corresponding to the processing mode.

15. The apparatus of claim 14, wherein:
the controller is configured to sequentially change the processing mode of the digital mirror device at predetermined intervals; and
the digital mirror device is configured to sequentially change the irradiation pattern of the light irradiated to the other surface of the transparent substrate at predetermined intervals.

16. The apparatus of claim 14, wherein the transparent substrate has a surface area larger than the irradiation pattern of the light irradiated from the digital optical unit, and the digital optical unit is moved along the other surface of the transparent substrate to form the high-aspect-ratio structure over an entire one surface of the transparent substrate.

17. The apparatus of claim 13, wherein the first lens portion and the second lens portion are each formed as a structure combining a plurality of lenses.

18. The apparatus of claim 13, wherein the second lens portion is configured to focus light delivered from the digital mirror device onto the transparent substrate to further miniaturize the fine pattern of the high-aspect-ratio structure.

19. The apparatus of claim 10, wherein the light source is equipped with a collimation lens to impart directivity to the light irradiated to the digital optical unit.

20. A method for manufacturing a high-aspect-ratio fine pattern, comprising:
irradiating light from a light source to a digital optical unit;
irradiating the light from the digital optical unit to a transparent substrate according to a predetermined irradiation pattern;
transmitting the light irradiated to the transparent substrate to a photo-curable resin applied on one surface of the transparent substrate; and
curing the photo-curable resin into a high-aspect-ratio structure in a fine pattern corresponding to the irradiation pattern of the light according to a self-propagating polymer waveguide (SPPW) process.

21. The method of claim 20, wherein the digital optical unit is provided as a digital light processor (DLP) configured to operate in any one mode of a plurality of processing modes corresponding to irradiation patterns of the light to process the irradiation pattern of the light irradiated to the other surface of the transparent substrate into a desired pattern, and wherein:
in the step of irradiating the light to the transparent substrate according to the irradiation pattern, the processing mode of the digital light processor is controlled to change the irradiation pattern of the light at predetermined intervals; and
in the step of curing the photo-curable resin into the high-aspect-ratio structure, different types of the high-aspect-ratio structure are formed in the photo-curable resin according to changes in the irradiation pattern of the light.

22. The method of claim 20, wherein, after the step of curing the photo-curable resin into the high-aspect-ratio structure is completed, the light source and the digital optical unit are moved to another portion of the transparent substrate with operation of the light source and the digital optical unit stopped, and the step of irradiating the light from the light source to the digital optical unit is repeated.
